(19) Europäisches Patentamt
European Patent Office
Office européen des brevets

(11) **EP 4 283 310 A2**

(12) **EUROPÄISCHE PATENTANMELDUNG**

(43) Veröffentlichungstag:
**29.11.2023 Patentblatt 2023/48**

(21) Anmeldenummer: **23168955.5**

(22) Anmeldetag: **20.04.2023**

(51) Internationale Patentklassifikation (IPC):
**G01R 15/14** (2006.01)     **H03F 3/45** (2006.01)

(52) Gemeinsame Patentklassifikation (CPC):
**G01R 15/144; H03F 3/45475; H03F 3/45596;**
G01R 19/0084

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(30) Priorität: **23.05.2022 DE 102022205116**

(71) Anmelder: **BSH Hausgeräte GmbH
81739 München (DE)**

(72) Erfinder: **Schmid, Florian
93173 Wenzenbach (DE)**

(54) **MESS-VORRICHTUNG ZUR SPANNUNGSMESSUNG ÜBER EINE ISOLATIONSBARRIERE HINWEG**

(57) Es wird eine Mess-Vorrichtung (110) zur Ermittlung von Messinformation in Bezug auf eine Eingangsspannung (103) beschrieben. Die Mess-Vorrichtung (110) umfasst einen Operationsverstärker (310) mit einem ersten Eingang (311) und einem zweiten Eingang (312), sowie mit einem Ausgang (313) zur Bereitstellung der Messinformation. Die Mess-Vorrichtung (110) umfasst ferner einen ersten Eingangsknoten (211) zur Kopplung mit einem ersten Pol der Eingangsspannung (103), sowie einen ersten Isolationswiderstand (212), der den ersten Eingangsknoten (211) mit dem ersten Eingang (311) des Operationsverstärkers (310) verbindet. Außerdem umfasst die Mess-Vorrichtung (110) einen zweiten Eingangsknoten (221) zur Kopplung mit einem zweiten Pol der Eingangsspannung (103), sowie einen zweiten Isolationswiderstand (222), der den zweiten Eingangsknoten (221) mit dem zweiten Eingang (312) des Operationsverstärkers (310) verbindet. Die Mess-Vorrichtung (110) umfasst ferner einen RückkopplungsWiderstand (302), der den Ausgang (313) des Operationsverstärkers (310) mit dem ersten Eingang (311) des Operationsverstärkers (310) verbindet, und einen Referenz-Widerstand (304), der den zweiten Eingang (312) des Operationsverstärkers (310) mit einem Referenzpotential (202, 332) verbindet.

Fig. 3b

EP 4 283 310 A2

**Beschreibung**

Die Erfindung betrifft eine Vorrichtung, insbesondere eine Schaltanordnung, zur Messung einer Spannung, insbesondere einer Wechselspannung oder einer Gleichspannung (z.B. der Zwischenkreisspannung eines Schaltnetzteils oder einer Motorelektronik).

Ein Hausgerät, wie z.B. eine Waschmaschine oder eine Spülmaschine, weist typischerweise einen Netzanschluss, insbesondere ein Schaltnetzteil, auf, mit dem das Hausgerät an ein Wechselstrom-Versorgungsnetz angeschlossen werden kann. Die von einem Versorgungsnetz bereitgestellte Netz- bzw. Versorgungsspannung kann Schwankungen in Bezug auf die Spannungshöhe und/oder in Bezug auf die Frequenz aufweisen. Derartige Schwankungen können zu Überspannungssituationen und/oder zu Schwankungen der Leistungsaufnahme in einem Hausgerät und somit ggf. zu Beeinträchtigungen des Betriebs des Hausgeräts führen.

Das vorliegende Dokument befasst sich mit der technischen Aufgabe, eine effiziente und präzise Messung der Netz- bzw. Versorgungsspannung eines elektrischen Geräts, insbesondere eines Hausgeräts, zu ermöglichen, um auch bei Schwankungen der Versorgungsspannung einen zuverlässigen und stabilen Betrieb des elektrischen Geräts zu ermöglichen. Die Messung soll dabei auch über eine Isolationsbarriere hinweg ermöglicht werden.

Die Aufgabe wird durch den Gegenstand des unabhängigen Patentanspruchs gelöst. Vorteilhafte Ausführungsformen sind insbesondere in den abhängigen Patentansprüchen definiert, in nachfolgender Beschreibung beschrieben oder in der beigefügten Zeichnung dargestellt.

Gemäß einem Aspekt der Erfindung wird eine Mess-Vorrichtung zur Ermittlung von Messinformation in Bezug auf eine Eingangsspannung, insbesondere in Bezug auf eine Alternating Current (AC) - Eingangsspannung oder in Bezug auf eine Direct Current (DC) - Eingangsspannung, beschrieben. Die Mess-Vorrichtung kann insbesondere eingerichtet sein, ein oder mehrere Messspannungen für die Eingangsspannung bereitzustellen, die in zuverlässiger und effizienter Weise in einer Safety Extra Low Voltage (SELV) oder einer Protective Extra Low Voltage (PELV) Umgebung von einem Mikroprozessor eingelesen werden können (über einen Analog-zu-Digital Wandler). Die Eingangsspannung, insbesondere die AC-Eingangsspannung, kann z.B. eine 230Volt (V) Versorgungsspannung sein.

Die Mess-Vorrichtung umfasst einen Operationsverstärker mit einem ersten Eingang (z.B. mit einem invertierenden und/oder Minus-Eingang) und mit einem zweiten Eingang (z.B. mit einem nicht-invertierenden und/oder Plus-Eingang), sowie mit einem Ausgang zur Bereitstellung der Messinformation. Der Operationsverstärker (und der in diesem Dokument beschriebene optionale Komparator) kann z.B. zwischen einer Betriebs-Spannung (z.B. 10V oder weniger, oder 5V oder weniger) und einer Referenzspannung bzw. einem Referenzpotential (z.B. Ground oder Masse) betrieben werden. Alternativ kann der Operationsverstärker (und ggf. der Komparator) zwischen einer positiven und einer negativen Betriebs-Spannung betrieben werden (die das Referenzpotential umschließen). In einem weiteren Beispiel kann der Operationsverstärker (und ggf. der Komparator) zwischen zwei Spannungen betrieben werden, die einen Spannungsbereich bilden, der den Teilbereich zwischen der Betriebs-Spannung und dem Referenzpotential (oder einen anderen Zielbereich für die Ausgangsspannung des Operationsverstärkers (bzw. des Komparators) umfasst.

Des Weiteren umfasst die Mess-Vorrichtung einen ersten Eingangsknoten zur Kopplung mit einem ersten Pol (z.B. mit dem Minus-Pol, mit einem Phasenleiter oder mit dem Neutralleiter) der Eingangsspannung, sowie einen ersten (ohmschen) Isolationswiderstand, der den ersten Eingangsknoten (direkt) mit dem ersten Eingang des Operationsverstärkers verbindet. Außerdem umfasst die Mess-Vorrichtung einen zweiten Eingangsknoten zur Kopplung mit einem zweiten Pol (in komplementärer Weise zu dem ersten Pol z.B. mit dem Plus-Pol, mit dem Neutralleiter oder mit dem Phasenleiter) der Eingangsspannung, sowie einen zweiten (ohmschen) Isolationswiderstand, der den zweiten Eingangsknoten (direkt) mit dem zweiten Eingang des Operationsverstärkers verbindet.

Die Eingangsspannung kann Teil eines ersten Spannungsbezugsystems sein. Die Eingangsspannung kann z.B. eine Amplitude von 100V oder mehr aufweisen. Das erste Spannungsbezugssystem kann z.B. eine Versorgungsspannung (z.B. eine 230V Versorgungsspannung) oder eine Zwischenkreisspannung (etwa eines Schaltnetzteils oder einer Elektronik für einen BLDC Motor, d.h. für einen bürstenlosen Gleichstrommotor) sein. Andererseits können die Betriebs-Spannung und/oder das Referenzpotential Teil eines zweiten Spannungsbezugsystems, insbesondere eines SELV oder eines PELV Spannungsbezugsystems, sein. Die Messinformation und/oder die Betriebs-Spannung können z.B. eine Amplitude von 50V oder weniger aufweisen. Zwischen den beiden Spannungsbezugssystemen kann eine Isolationsbarriere angeordnet sein, die insbesondere durch die Isolationswiderstände der Mess-Vorrichtung bereitgestellt wird. Es kann somit in effizienter und zuverlässiger Weise (an dem Ausgang des Operationsverstärkers) eine Messung der Eingangsspannung aus einem anderen Spannungsbezugsbereich heraus ermöglicht werden.

Die Mess-Vorrichtung umfasst ferner einen Rückkopplungs-Widerstand, der den Ausgang des Operationsverstärkers (direkt) mit dem ersten Eingang des Operationsverstärkers verbindet. Des Weiteren umfasst die Mess-Vorrichtung einen Referenz-Widerstand, der den zweiten Eingang des Operationsverstärkers (direkt oder über eine Offset-Einheit) mit dem Referenzpotential (z.B. mit Ground oder Masse) verbindet. So kann eine besonders präzise Bereitstellung von Messinformation in Bezug auf die Eingangsspannung am Ausgang des Operationsverstärkers bereitgestellt werden.

Der erste Isolationswiderstand und der zweite Isolationswiderstand können jeweils einen derart hohen Widerstandswert aufweisen, dass durch den ersten Isolationswiderstand und durch den zweiten Isolationswiderstand eine galvanische Isolation mit einem Leckstrom bewirkt wird, der kleiner als ein (innerhalb einer Vorschrift, etwa der SELV-Norm) vordefinierter Leckstrom-Schwellenwert ist. Alternativ oder ergänzend können der erste Isolationswiderstand und/oder der zweite Isolationswiderstand jeweils mehrere in Serie angeordnete Teil-Widerstände aufweisen. So kann in besonders effizienter Weise eine Isolationsbarriere zwischen dem ersten Spannungsbezugsbereich und dem zweiten Spannungsbezugsbereich bereitgestellt werden.

Die Widerstandswerte des ersten Isolationswiderstands und des zweiten Isolationswiderstands sind bevorzugt identisch oder weichen um höchstens 5% voneinander ab. Ferner sind die Widerstandswerte des Rückkopplungs-Widerstands und des Referenz-Widerstands bevorzugt identisch oder weichen um höchstens 5% voneinander ab. So kann eine besonders präzise und effiziente Messung der Eingangsspannung über die Ausgangsspannung am Ausgang des Operationsverstärkers ermöglicht werden.

Die Mess-Vorrichtung kann eine Offset-Einheit (z.B. eine Spannungsquelle) umfassen, die eingerichtet ist, das Referenzpotential um eine Offset-Spannung zu verschieben, um ein modifiziertes Referenzpotential zu generieren. Der Referenz-Widerstand kann dann derart angeordnet sein, dass der Referenz-Widerstand den zweiten Eingang des Operationsverstärkers (direkt) mit dem modifizierten Referenzpotential verbindet.

Die Eingangsspannung kann an unterschiedlichen Zeitpunkten unterschiedliche Polaritäten aufweisen. Die Eingangsspannung kann z.B. eine AC-Spannung sein. Die Offset-Spannung kann derart hoch sein, dass die Differenzspannung zwischen dem ersten Eingang und dem zweiten Eingang des Operationsverstärkers an den unterschiedlichen Zeitpunkten jeweils eine einheitliche Polarität aufweist (bevorzugt zwischen 0V und der Betriebs-Spannung). Alternativ oder ergänzend kann die Offset-Spannung derart hoch sein, dass die Ausgangsspannung am Ausgang des Operationsverstärkers an den unterschiedlichen Zeitpunkten jeweils eine einheitliche Polarität aufweist (bevorzugt zwischen 0V und der Betriebs-Spannung).

Die Ausgangsspannung am Ausgang des Operationsverstärkers kann ausgebildet sein, Werte aus einem möglichen Spannungsbereich anzunehmen und/oder eine dem Operationsverstärker nachgeschaltete Mess- und/oder Auswerteelektronik kann ausgebildet sein, Messwerte aus dem möglichen Spannungsbereich zu erfassen. Die Offset-Spannung kann dann der Hälfte des möglichen Spannungsbereichs entsprechen. In einem bevorzugten Beispiel entspricht die Offset-Spannung der Hälfte der Spannungsdifferenz zwischen der Betriebs-Spannung und dem Referenzpotential, oder weicht um höchstens 5% davon ab. Die Ausgangsspannung kann dabei zwischen dem Ausgang des Operationsverstärkers und dem Referenzpotential (z.B. Ground oder Masse) gemessen (und an einen Analog-zu-Digital-Wandler übergeben) werden.

Es kann somit eine Offset-Einheit bereitgestellt werden, die es ermöglicht, auch bei Messung einer AC-Eingangsspannung eine Ausgangsspannung (relativ zu dem Referenzpotential) am Ausgang des Operationsverstärkers bereitzustellen, die keine Polaritätswechsel aufweist. So kann eine besonders effiziente und präzise Messung der Eingangsspannung ermöglicht werden.

Die Mess-Vorrichtung kann somit ausgebildet sein, an dem Ausgang des Operationsverstärkers als Messinformation eine Ausgangsspannung als Messung der Eingangsspannung bereitzustellen, die einer skalierten und/oder verschobenen Version der Eingangsspannung entspricht. Dabei kann die Ausgangsspannung eine Amplitude von 50V oder weniger aufweisen (auch wenn die Eingangsspannung eine Amplitude von 100V oder mehr aufweist). Es kann somit eine besonders effiziente Messung der Eingangsspannung ermöglicht werden.

Die Mess-Vorrichtung kann einen Komparator umfassen, der ausgebildet ist, die Ausgangsspannung an dem Ausgang des Operationsverstärkers mit einem von dem Referenzpotential abgeleiteten Vergleichspotential zu vergleichen. Dabei kann das Vergleichspotential das modifizierte Referenzpotential sein, das dem um die Offset-Spannung verschobenen Referenzpotential entspricht. Der Komparator kann somit ausgebildet sein, als Ausgangssignal des Komparators einen Polaritätswechsel und/oder einen Nulldurchgang der Eingangsspannung anzuzeigen. Durch die Bereitstellung eines Komparators kann eine effiziente und präzise Nulldurchgangs- und/oder Frequenzmessung einer (AC-) Eingangsspannung ermöglicht werden.

Die Mess-Vorrichtung kann einen Analog-zu-Digital-Wandler umfassen, der eingerichtet ist, die Ausgangsspannung am Ausgang des Operationsverstärkers oder eine davon abgeleitete Spannung (z.B. die Ausgangsspannung bzw. das Ausgangssignal des Komparators) in eine digitale Messspannung zu wandeln.

Des Weiteren kann die Mess-Vorrichtung einen Prozessor umfassen, der eingerichtet ist, auf Basis der digitalen Messspannung als Messinformation einen Messwert für die Eingangsspannung, insbesondere einen Messwert für die Amplitude oder für die gesamte Signalform der Eingangsspannung, zu ermitteln. Alternativ oder ergänzend kann ein Polaritätswechsel und/oder ein Nulldurchgang der Eingangsspannung detektiert werden, und/oder es kann die Frequenz der Eingangsspannung ermittelt werden (wenn die digitale Messspannung das Ausgangssignal des Komparators anzeigt). Es kann somit eine effiziente und präzise Nutzung der Messinformation ermöglicht werden.

Gemäß einem weiteren Aspekt wird ein Hausgerät (z.B. eine Waschmaschine, eine Spülmaschine, ein Ofen, ein Herd, eine Küchenmaschine, ein Staubsauger, ein Trockner, ein Kühlschrank, etc.) beschrieben, das die in diesem Dokument beschriebene Mess-Vorrichtung umfasst. Das Hausgerät kann insbesondere einen Netzanschluss zur Anbindung des Hausgeräts an eine AC-Versorgungsspannung umfassen. Die Mess-Vorrichtung kann eingerichtet sein, auf Basis der AC-Versorgungsspannung Messinformation in Bezug auf die Versorgungsspannung zu ermitteln.

Das Hausgerät kann ferner eine Steuereinheit umfassen, die eingerichtet ist, eine Funktion des Hausgeräts in Abhängigkeit von der Messinformation, insbesondere in Abhängigkeit von einem Messwert der Amplitude der Versorgungsspannung, zu betreiben. Beispielsweise kann eine Leistungssteuerung bzw. -regelung des Hausgeräts in Abhängigkeit von der Messinformation erfolgen. So kann ein besonders sicherer und zuverlässiger Betrieb des Hausgeräts ermöglicht werden.

Es ist zu beachten, dass jegliche Aspekte der in diesem Dokument beschriebenen Mess-Vorrichtung in vielfältiger Weise miteinander kombiniert werden können. Insbesondere können die Merkmale der Patentansprüche in vielfältiger Weise miteinander kombiniert werden.

Im Weiteren wird die Erfindung anhand von in der beigefügten Zeichnung dargestellten Ausführungsbeispielen näher beschrieben. Dabei zeigen

Figur 1    ein Blockdiagramm eines beispielhaften Hausgeräts;
Figur 2    ein Blockdiagramm einer beispielhaften Mess-Vorrichtung zur Spannungsmessung;
Figur 3a   eine Operationsverstärker-basierte Grundschaltung;
Figur 3b   eine beispielhafte Mess-Vorrichtung mit einem Operationsverstärker;
Figur 3c   eine weitere beispielhafte Mess-Vorrichtung mit einem Operationsverstärker;
Figur 4a   eine beispielhafte Mess-Vorrichtung zur Messung der Amplitude einer AC-Eingangsspannung; und
Figur 4b   eine beispielhafte Mess-Vorrichtung zur Messung des Nulldurchgangs und/oder der Frequenz einer AC-Eingangsspannung.

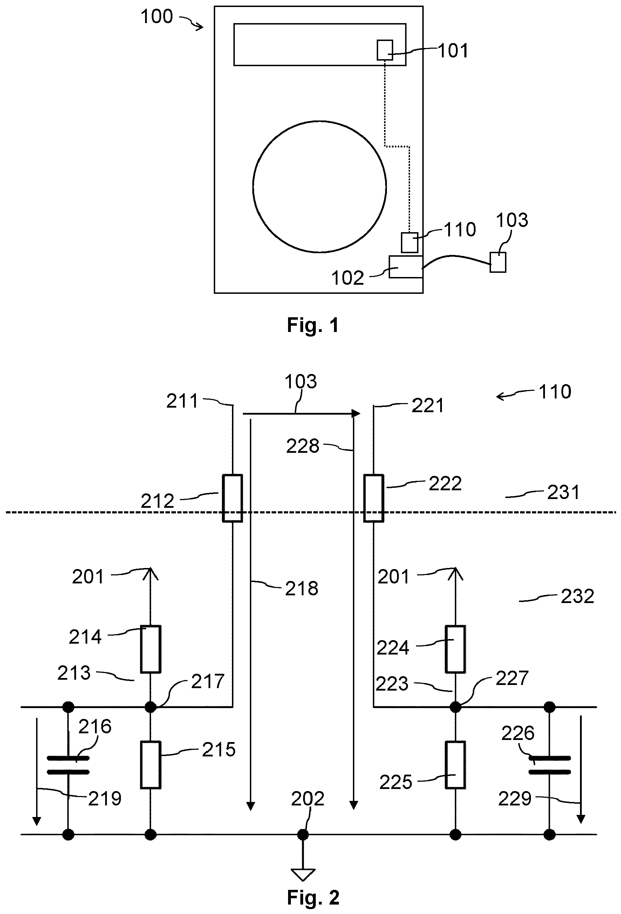

Wie eingangs dargelegt, befasst sich das vorliegende Dokument damit, auch bei Schwankungen der Versorgungsspannung in effizienter Weise einen stabilen und zuverlässigen Betrieb eines Hausgeräts zu ermöglichen. In diesem Zusammenhang zeigt Fig. 1 ein beispielhaftes Hausgerät 100, z.B. eine Waschmaschine, mit einem Netzanschluss 102, insbesondere mit einem Schaltnetzteil, über das das Hausgerät 100 an eine Wechselstrom-Versorgungsspannung 103 angeschlossen werden kann. Das Hausgerät 100 umfasst eine Mess-Vorrichtung 110, die eingerichtet ist, ein oder mehrere Messsignale in Bezug auf die Versorgungsspannung 103 zu erfassen. Das eine oder die mehreren Messsignale (z.B. die Ausgangsspannung eines Operationsverstärkers und/oder das Ausgangssignal eines Komparators) können durch eine Steuereinheit 101, z.B. durch einen Mikroprozessor, des Hausgeräts 100 ausgewertet werden, insbesondere um den Betrieb des Hausgeräts 100 an eine jeweils aktuelle Eigenschaft, z.B. Amplitude und/oder Frequenz, der Versorgungs- bzw. Netzspannung 103 anzupassen. So kann auch bei Schwankungen der Versorgungsspannung 103 ein stabiler und zuverlässiger Betrieb des Hausgeräts 100 ermöglicht werden.

Fig. 1 zeigt somit ein Hausgerät 100, das über einen Netzstecker mit dem öffentlichen Stromnetz verbunden und so mit elektrischer Energie versorgt werden kann. Das öffentliche Stromnetz kann als "Spannungsbezugssystem A" betrachtet werden. Spannungsführende Teile in und an dem Hausgerät 100, welche eine Verbindung zu diesem Spannungsbezugssystem haben, müssen typischerweise elektrisch isoliert und vor Berührung durch einen Benutzer des Hausgeräts 100 geschützt werden. So können in zuverlässiger Weise Stromschläge, bedingt durch die relativ hohe Spannung dieses Spannungsbezugssystems, vermieden werden. Eine derartige Isolation ist in einem Hausgerät 100 beispielsweise im Bereich der Benutzerschnittstelle oder bei Anbaugeräten wie beispielsweise einem Bratenthermometer ggf. nicht möglich oder mit einem relativ hohen Aufwand verbunden.

Aus diesem Grund weist ein Hausgerät 100 typischerweise ein eigenes Stromnetz auf, das als "Spannungsbezugssystem B" bezeichnet werden kann und das eine gegenüber der Netzspannung 103 reduzierte (Betriebs-) Spannung (in diesem Dokument auch als VDD bezeichnet) aufweist, durch die Stromschläge für einen Benutzer zuverlässig vermieden werden können. Nicht isolierfähige Komponenten des Hausgeräts 100 können innerhalb des Spannungsbezugssystems B sicher mit elektrischer Energie versorgt werden.

Ein Pol des öffentlichen Stromnetzes ist typischerweise mit Erde oder Ground verbunden, was es erforderlich macht, das Spannungsbezugssystem A und das Spannungsbezugssystem B galvanisch voneinander zu isolieren. Die galvanische Trennung kann durch eine sogenannte Isolationsbarriere bewirkt werden. Die Energieübertragung zwischen beiden Spannungsbezugssystemen kann magnetisch mithilfe eines Transformators (als Teil der Isolationsbarriere) erfolgen.

Eine Isolationsbarriere weist meist einen maximal zulässigen Ableitstrom (der auch als Leckstrom bezeichnet wird) und/oder ein oder mehrere weitere Isolationseigenschaften, wie z.B. einen bestimmten geometrischen Abstand und/oder eine bestimmte Spannungsfestigkeit, auf. Durch eine Isolationsbarriere geht meist der elektrisch definierte Bezug der beiden Spannungsbezugssysteme zueinander, die von der Isolationsbarriere galvanisch voneinander getrennt werden, verloren. Wenn die Spannung des Spannungsbezugssystems A innerhalb des Spannungsbezugssystems B gemessen werden soll, ist es daher typischerweise erforderlich, dem Spannungsbezugssystem B diese relative Spannungsinformation zu übermitteln, ohne dabei die Isolationsbarriere außer Kraft zu setzen.

Ein Beispiel für eine Spannungsmessung über eine Isolationsbarriere hinweg ist die Messung der Netzspannung 103. Gemessene Information in Bezug auf die Netzspannung 103 kann z.B. dafür verwendet werden, eine Schutzfunktion in dem Hausgerät 100 zu aktivieren oder ein oder mehrere Prozesse, wie beispielsweise das Abtauen eines Kühlgeräts mithilfe von Heizungen, energetisch zu optimieren.

In diesem Dokument wird eine Mess-Vorrichtung 110 zur Messung einer elektrischen Spannung 103 über eine Isolationsbarriere hinweg beschrieben, die einen für die Isolationsbarriere vorgesehenen maximal zulässigen Leckstrom und/oder ein oder mehrere weitere Isolationseigenschaften bzw. Isolationsanforderungen erfüllt.

Fig. 2 zeigt ein Schaltdiagramm einer beispielhaften Mess-Vorrichtung 110. Die Mess-Vorrichtung 110 ist eingerichtet, die Potenzialdifferenz 103 zwischen den Punkten 211 und 221 (d.h. die Eingangsspannung 103) eindeutig durch die Differenz der Messspannungen 219 (zwischen dem ersten Messpunkt 217 und dem Referenzpotential 202) und 229 (zwischen dem zweiten Messpunkt 227 und dem Referenzpotential 202) zu bestimmen.

Die Offset-Widerstände 214 und 224 stellen eine Verbindung der Messpunkte 217 und 227 zu der Betriebs-Spannung 201 des zweiten Spannungsbezugsystems B 232 her. Die Betriebs-Spannung 201 kann bezogen auf das Referenzpotential 202 einen festen Wert aufweisen. So kann den Messspannungen 219 und 229 jeweils eine Offsetspannung hinzugefügt werden, welche es ermöglicht, die Messspannungen 219, 229 jeweils ausschließlich im positiven Bereich zu halten. Dies ist vorteilhaft, um die einzelnen Messspannungen 219, 229 jeweils über einen unipolaren Analog-Digital-Wandler in einem Mikroprozessor aufzunehmen.

Die Widerstände 212, 214 und 215 sowie die Widerstände 222, 224 und 225 bilden jeweils einen Spannungsteiler 213, 223 zwischen der Spannung 218 und der ersten Messspannung 219 bzw. zwischen der Spannung 228 und der zweiten Messspannung 229.

Die Potenzialdifferenz zwischen den Eingangsknoten 211 und 221 stellt die Eingangsspannung 103 dar. Dabei sind die Potenzialdifferenzen oder Spannungen 218 sowie 228 absolut gesehen typischerweise nicht von Bedeutung. Störungen, Gleichtaktspannungen oder zusätzliche Impedanzen zwischen den Eingangsknoten 211 und 221 und dem Referenzpotential 202 löschen sich durch die Differenzbildung aus und es bleibt nur die Eingangsspannung 103 als Ergebnis bestehen. So ist es möglich, in einem System, bei dem ein Punkt als Potenzialbezugspunkt ("GND") (mit dem Referenzpotential 202) festgelegt ist, eine Spannung zwischen zwei Eingangsknoten 211, 221 zu messen, unabhängig von den jeweiligen absoluten Potenzialdifferenzen 218, 228 der einzelnen Eingangsknoten 211, 221 zu dem Potenzialbezugspunkt des Systems. So wird eine hochohmige Anbindung beider Eingangsknoten 211, 221 an die Mess-Vorrichtung 110 ermöglicht.

Die Kondensatoren 216 und 226 können zur Tiefpassfilterung der Messspannung verwendet werden. Wenn keine Tiefpassfilterung benötigt wird, können die Kondensatoren 216, 226 entfallen.

Durch die Verwendung von relativ hohen Widerstandswerten der Isolationswiderstände 212 und 222 und durch eine entsprechende Begrenzung der elektrischen Ströme über die Isolationswiderstände 212, 222, wird eine Spannungsmessung über eine Isolationsbarriere zwischen dem ersten Spannungsbezugssystem A 231 und dem zweiten Spannungsbezugssystem B 232 hinweg ermöglicht.

Je höher der Widerstandswert der Isolationswiderstände 212 und 222 gewählt wird, desto größer ist typischerweise der Störeinfluss von parasitären Kapazitäten auf die absoluten Spannungen 218 und 228. Durch die differenzielle Spannungsmessung löschen sich diese Störeinflüsse jedoch im Rahmen der Differenzbildung komplett aus, sodass auch bei Reduzierung der Leckströme der Isolationsbarriere durch Erhöhung des Widerstandswertes der Isolationswiderstände 212 und 222 eine präzise Messung der Eingangsspannung 103 über die Differenz der Messspannungen 219, 229 ermöglicht wird. Dabei verwendet die in Fig. 2 dargestellte Mess-Vorrichtung 110 ausschließlich passive Bauteile und ermöglicht somit eine besonders effiziente Implementierung.

Bei der in Fig. 2 dargestellten Mess-Vorrichtung 110 müssen die zwei Messspannungen 219, 229 nahezu zeitgleich gemessen werden, was typischerweise die Verwendung von mindestens zwei Analog-zu-Digital-Wandler-Eingängen und ein möglichst zeitnahes Abtasten der beiden Eingänge erfordert. Falls keine ausreichende Anzahl von Analog-zu-Digital-Wandler-Eingängen verfügbar ist und/oder falls ein nahezu zeitgleiches Abtasten nicht möglich ist, so kann die Mess-Vorrichtung 110 aus Fig. 2 typischerweise nicht verwendet werden.

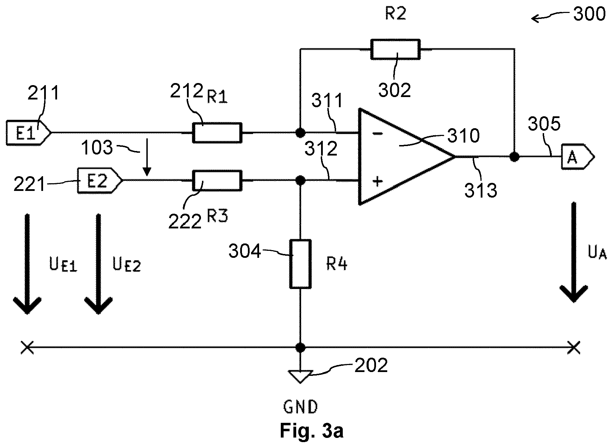

Fig. 3a zeigt eine beispielhafte Operationsverstärker-Grundschaltung 300 mit der Funktion eines Subtrahierers. Die Schaltung 300 ist ausgebildet, die beide Eingangsspannungen "$U_{E2}$" 221 und "$U_{E1}$" 211 voneinander zu subtrahieren, und liefert basierend darauf ein Ergebnis als Ausgangsspannung "$U_A$" an dem Ausgangsknoten 305 (relativ zu dem Referenzpotential 202). Die beiden Eingangsspannungen 211, 221 werden über Widerstände 212, 222 zu dem invertierenden Eingang 311 bzw. zu dem nicht-invertierenden Eingang 312 eines Operationsverstärkers 310 geführt. Der Ausgang 313 des Operationsverstärkers 310 ist über einen Rückkopplungs-Widerstand 302 mit dem invertierenden Eingang 311 gekoppelt. Der nicht-invertierende Eingang 312 ist über einen Referenz-Widerstand 304 mit dem Referenzpotential 202 gekoppelt.

Für einen idealen Operationsverstärker 310 kann der Zusammenhang zwischen der Ausgangsspannung und den Eingangsspannungen 211, 221 beschrieben werden, als

$$U_A = U_{E2} * \frac{R1 + R2}{R1} * \frac{R4}{R3 + R4} - U_{E1} * \frac{R2}{R1}$$

Durch Aufstellen folgender Bedingungen für die Widerstandswerte der Widerstände 212, 222, 302, 304: R1=R3 und R2=R4 kann der Zusammenhang durch folgende Formel dargestellt werden:

$$U_A = \frac{R2}{R1} * (U_{E2} - U_{E1})$$

Wie aus dieser Formel zu entnehmen ist, kann mithilfe der Schaltung 300 eine Spannungsmessung zwischen den Punkten "E1" und "E2" ermöglicht werden. Die absoluten elektrischen Spannungen zwischen den Punkten "E1" 211 und "E2" 221 zu dem Punkt "GND" (mit dem Referenzpotential 202) spielen dabei keine Rolle mehr. Es wird nur die Potentialdifferenz 103 zwischen den Punkten "E1" 211 und "E2" 221 ausgewertet.

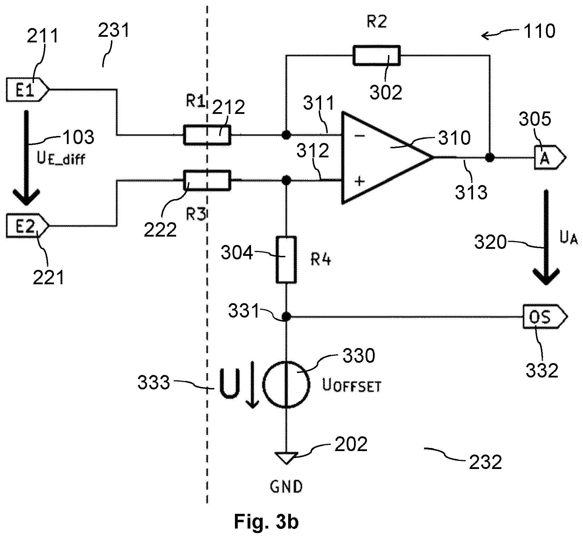

Das Schaltungsprinzip aus Fig. 3a kann dazu verwendet werden, eine Spannung über eine Isolationsbarriere hinweg in einem Hausgerät 100 zu messen, wie beispielhaft in Fig. 3b dargestellt. Die Werte der Widerstände "R1" und "R3" sowie "R2" und "R4" sind bevorzugt identisch, um den absoluten Spannungsbezug zwischen den beiden Spannungsbezugssystemen "A" 231 und "B" 232 zu eliminieren. Als Folge daraus, ist nur noch die Potenzialdifferenz 103 zwischen den Punkten "E1" 211 und "E2" 221 relevant.

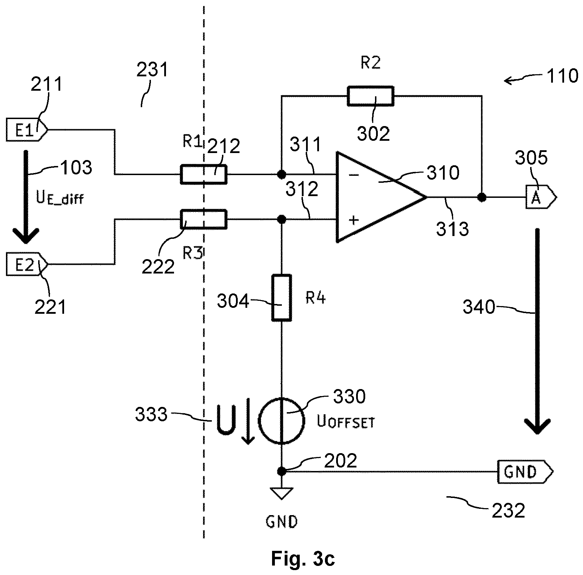

In den in einem Hausgerät 100 verbauten elektronischen Schaltungen 102 steht meist ausschließlich eine positive Betriebs-Spannung 201 (zum Betrieb des Operationsverstärkers 310) zur Verfügung. Ferner erfolgt eine Spannungsmessung mit einem Analog-zu-Digital-Wandler meist nur im positiven Spannungsbereich. Die Mess-Vorrichtung 110 kann aus diesem Grund eine Offset-Einheit 330 (z.B. eine (ideale) Spannungsquelle) umfassen, die eingerichtet ist, eine Offset-Spannung 333 zu bewirken, durch die eine Ausgangsspannung 340 am Ausgangspunkt 305 bewirkt wird, die bezogen auf das Referenzpotential 202 ausschließlich im positiven Bereich liegt (siehe Fig. 3c). Durch Subtraktion der Offsetspannung 333 von dieser Ausgangsspannung 340 erhält man somit einen Messwert 320, der positiv und negativ sein kann und somit beide Polaritäten der zu messenden Spannung 103 abbilden kann (siehe Fig. 3b), z.B. um den Nulldurchgang der zu messenden Spannung 103 zu detektieren. Um eine möglichst große Aussteuerung in beide Spannungsrichtungen zu ermöglichen, entspricht die Offset-Spannung 333 bevorzugt der halben Spannung des gesamten Messbereichs (der typischerweise der Differenz aus der Betriebs-Spannung 201 und dem Referenzpotential 202 entspricht). Bei einem Messbereich von 0V bis 3,3V kann z.B. eine Offset-Spannung "$U_{OFFSET}$" 333 von ca. 1,65V gewählt werden. Allgemein kann als Offset-Spannung 333 die halbe Versorgungs- bzw. Betriebsspannung 201 verwendet werden. Die Offset-Einheit 330 kann zwischen dem Referenzpotential 202 und dem Referenz-Widerstand 304 angeordnet sein, so dass an dem Verbindungspunkt 331 zwischen Referenz-Widerstand 304 und Offset-Einheit 330 eine modifiziertes Referenzpotential 332 bereitgestellt werden kann, das dem um die Offset-Spannung 333 verschobenen Referenzpotential 202 entspricht. Die Ausgangsspannung 320 kann relativ zu dem modifizierten Referenzpotential 332 bereitgestellt werden.

Die Isolationswiderstände "R1" 212 und "R3" 222 stellen die Widerstände dar, welche über die Isolationsbarriere zwischen den Spannungsbezugssystemen 231, 232 hinweg reichen. Diese sind bevorzugt derart ausgebildet, dass die Isolationswiderstände 212, 222 die Eigenschaften der Isolation zwischen den Spannungsbezugssystemen "A" 231 und "B" 232 nicht beeinträchtigen. Zu diesem Zweck unterschreiten die Widerstandswerte der Isolationswiderstände 212, 222 typischerweise nicht einen gewissen Mindest-Widerstandswert. Alternativ oder ergänzend erfüllen die Isolationswiderstände 212, 222 bevorzugt eine gewisse Norm und/oder bestehen jeweils aus mehreren hintereinander geschalteten Teil-Widerständen.

Das differentielle Messprinzip der Mess-Vorrichtung 110 ermöglicht eine nahezu beliebige Auswahl des Widerstandswertes von "R1" 212 und "R3" 222. Die beiden Spannungsbezugssysteme "A" 231 und "B" 232 können somit sehr hochohmig voneinander getrennt werden, sodass eine dazwischen befindliche Isolation nicht beeinträchtigt wird. Die Ausgangsspannung "$U_A$" 320 der Mess-Vorrichtung 110 aus Fig. 3b kann durch folgende Formel ermittelt werden:

$$U_A = \frac{R2}{R1} * (-U_{E\_diff})$$

Figuren 3b und 3c zeigen keine Bauteile zur Filterung des Messsignals (d.h. der Ausgangsspannung 320) und/oder zur Schutzbeschaltung, können aber nach Bedarf hinzugefügt werden (ohne eine Änderung der Grundfunktionalität der Schaltung 110 und der Messung von Spannungen über eine Isolationsbarriere hinweg zu bewirken).

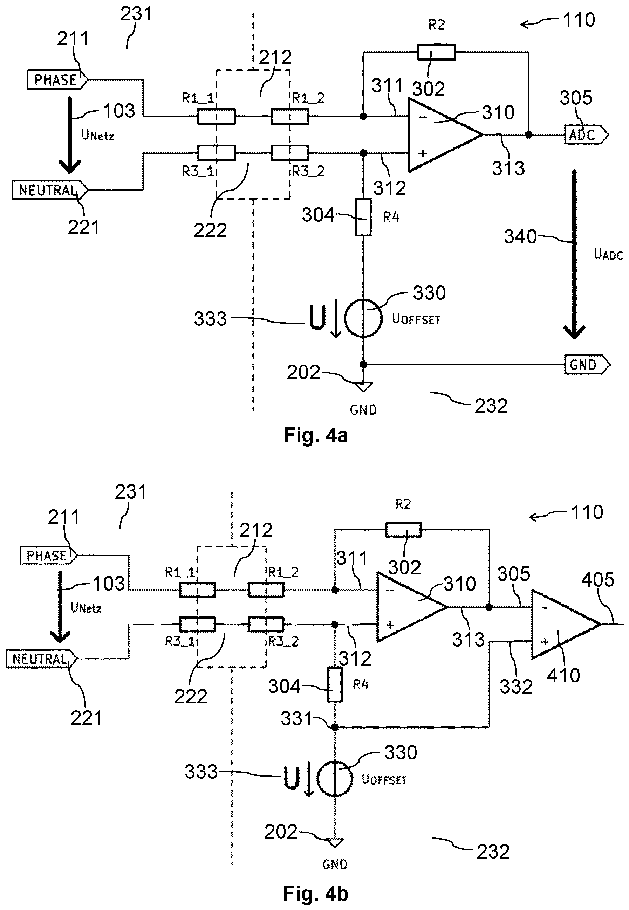

Fig. 4a veranschaulicht die Anwendung der Mess-Vorrichtung 110 zur Messung der Netzspannung in einem Hausgerät 100. Die Anschlüsse "E1" 211 und "E2" 221 können mit den beiden Anschlüssen "PHASE" und "NEUTRAL" des Stromversorgungsnetzes verbunden werden. Aus Sicherheitsgründen können die Isolationswiderstände "R1" und "R3" 212, 222 jeweils durch zwei seriell geschaltete Widerstände implementiert werden ("R1" wird zu "R1_1" und "R1_2" und "R3" wird zu "R3_1" und "R3_2"). Der Widerstandswert sollte ausreichend hoch gewählt werden, um die Isolationsbarriere beizubehalten. Die Ausgangsspannung "$U_{ADC}$" 340 am Punkt "ADC" 305 (relativ zu dem Referenzpotential 202) stellt die heruntergeteilte, mit einem Offset "$U_{OFFSET}$" 333 versehene, gemessene Netzspannung dar. Der Nullpunkt befindet sich bei dem Spannungswert "$U_{OFFSET}$". Somit ist es möglich, beide Polaritäten der Eingangsspannung, in diesem Fall der Netzspannung, zu erfassen, ohne eine negative Spannung mit einem Analog-zu-Digital-Wandler (auf Englisch Analog-to-Digital Converter, ADC) messen zu müssen. Aus der gemessenen Spannung "$U_{ADC}$" 340 kann die Netzspannung "$U_{Netz}$" mit folgender Formel berechnet werden:

$$U_{Netz} = \frac{R1}{R2} * (U_{OFFSET} - U_{ADC})$$

Ein weiterer Anwendungsfall ist die Erkennung des Nulldurchgangs der Netzspannung, wie beispielhaft in Fig. 4b dargestellt. Die Erkennung des Nulldurchgangs kann beispielsweise für das netzspannungssynchrone Schalten von Aktoren in einem Hausgerät 100 verwendet werden. Die Messung der Netzfrequenz als Taktgeber ist ein weiterer Anwendungsfall einer solchen Nulldurchgangserkennung.

Für eine Nulldurchgangserkennung kann die Polarität der Ausgangsspannung "$U_A$" des Operationsverstärkers 310 ausgewertet werden. Zu diesem Zweck kann ein Komparator 410 verwendet werden. Der Komparator 410 wandelt die Polarität des Signals in ein Digitalsignal mit den beiden Zuständen High und Low um. Dieses Ausgangssignal des Komparators 410 kann dann am Ausgangspunkt 405 des Komparators 410 abgegriffen werden. Der Zustand des Signals an dem Ausgangspunkt 405 zeigt somit die jeweils aktuelle Polarität der Netzspannung an. Ein Zustandswechsel des Signals an dem Ausgangspunkt 405 entspricht somit einem Nulldurchgang der Netzspannung "$U_{Netz}$".

Die in diesem Dokument beschriebene Mess-Vorrichtung 110 weist einen relativ geringen Bauteilaufwand und Platzbedarf auf. Ferner ist es ausreichend, eine einzige Spannung zu messen, sodass nur ein einziger Analog-zu-Digital-Wandler Eingang benötigt wird. Des Weiteren ist die Ausgangsimpedanz der Schaltung 110 aufgrund des Operationsverstärkers 310 relativ klein, was eine relativ schnelle Abtastung der gemessenen Spannung ermöglicht. Die Mess-Vorrichtung 110 ermöglicht eine Netzspannungsmessung und/oder eine Nulldurchgangserkennung in Geräten 100, in denen keine netzpotentialbezogene Messschaltung vorgesehen oder möglich ist.

Die Mess-Vorrichtung 110 weist primär passive Bauteile in Form von Widerständen auf, sodass Störeinflüsse durch Bauteiltoleranzen effektiv berechnet und kompensiert werden können. Die Bauteile weisen in erster Näherung ein lineares Verhalten auf, was eine einfache Kalibrierung der Schaltung 110 während des Fertigungsprozesses ermöglicht.

Die vorliegende Erfindung ist nicht auf die gezeigten Ausführungsbeispiele beschränkt. Insbesondere ist zu beachten, dass die Beschreibung und die Figuren nur das Prinzip der vorgeschlagenen Mess-Vorrichtung veranschaulichen sollen.

**Patentansprüche**

1. Mess-Vorrichtung (110) zur Ermittlung von Messinformation in Bezug auf eine Eingangsspannung (103); wobei die Mess-Vorrichtung (110) umfasst,

   - einen Operationsverstärker (310) mit einem ersten Eingang (311) und einem zweiten Eingang (312), sowie mit einem Ausgang (313) zur Bereitstellung der Messinformation;
   - einen ersten Eingangsknoten (211) zur Kopplung mit einem ersten Pol der Eingangsspannung (103);
   - einen ersten Isolationswiderstand (212), der den ersten Eingangsknoten (211) mit dem ersten Eingang (311) des Operationsverstärkers (310) verbindet;
   - einen zweiten Eingangsknoten (221) zur Kopplung mit einem zweiten Pol der Eingangsspannung (103);
   - einen zweiten Isolationswiderstand (222), der den zweiten Eingangsknoten (221) mit dem zweiten Eingang (312) des Operationsverstärkers (310) verbindet;
   - einen Rückkopplungs-Widerstand (302), der den Ausgang (313) des Operationsverstärkers (310) mit dem ersten Eingang (311) des Operationsverstärkers (310) verbindet; und
- einen Referenz-Widerstand (304), der den zweiten Eingang (313) des Operationsverstärkers (310) mit einem Referenzpotential (202, 332) verbindet.

2. Mess-Vorrichtung (110) gemäß Anspruch 1, wobei der erste Isolationswiderstand (212) und der zweite Isolationswiderstand (222) jeweils einen derart hohen Widerstandswert aufweisen, dass durch den ersten Isolationswiderstand (212) und durch den zweiten Isolationswiderstand (222) eine galvanische Isolation mit einem Leckstrom bewirkt wird, der kleiner als ein vordefinierter Leckstrom-Schwellenwert ist.

3. Mess-Vorrichtung (110) gemäß einem der vorhergehenden Ansprüche, wobei

- die Eingangsspannung (103) Teil eines ersten Spannungsbezugsystems (231), insbesondere eines Elektrizitätsversorgungsnetzes oder eines Zwischenkreises eines elektrischen Geräts (100), ist; und/oder
- eine Betriebs-Spannung (201) und/oder das Referenzpotential (202) zum Betrieb des Operationsverstärkers (310) Teil eines zweiten Spannungsbezugsystems (232), insbesondere eines Safety Extra Low Voltage, kurz SELV, oder eines Protective Extra Low Voltage, kurz PELV, Spannungsbezugsystems, sind.

4. Mess-Vorrichtung (110) gemäß einem der vorhergehenden Ansprüche, wobei der erste Isolationswiderstand (212) und/oder der zweite Isolationswiderstand (222) jeweils mehrere in Serie angeordnete Teil-Widerstände aufweisen.

5. Mess-Vorrichtung (110) gemäß einem der vorhergehenden Ansprüche, wobei

- Widerstandswerte des ersten Isolationswiderstands (212) und des zweiten Isolationswiderstands (222) identisch sind oder um höchstens 5% voneinander abweichen; und/oder
- Widerstandswerte des Rückkopplungs-Widerstands (302) und des Referenz-Widerstands (304) identisch sind oder um höchstens 5% voneinander abweichen.

6. Mess-Vorrichtung (110) gemäß einem der vorhergehenden Ansprüche, wobei

- die Mess-Vorrichtung (110) eine Offset-Einheit (330) umfasst, die eingerichtet ist, das Referenzpotential (202) um eine Offset-Spannung (333) zu verschieben, um ein modifiziertes Referenzpotential (332) zu generieren; und
- der Referenz-Widerstand (304) den zweiten Eingang (312) des Operationsverstärkers (310) mit dem modifizierten Referenzpotential (332) verbindet.

7. Mess-Vorrichtung (110) gemäß Anspruch 6, wobei

- die Eingangsspannung (103) an unterschiedlichen Zeitpunkten unterschiedliche Polaritäten aufweist; und
- die Offset-Spannung (333) derart hoch ist, dass
- eine Differenzspannung zwischen dem ersten Eingang (311) und dem zweiten Eingang (312) des Operationsverstärkers (310) an den unterschiedlichen Zeitpunkten jeweils eine einheitliche Polarität aufweist; und/oder
- eine Ausgangsspannung (340) am Ausgang (313) des Operationsverstärkers (310) an den unterschiedlichen Zeitpunkten jeweils eine einheitliche Polarität aufweist.

8. Mess-Vorrichtung (110) gemäß einem der Ansprüche 6 bis 7, wobei

- der Operationsverstärker (310) zwischen einer Betriebs-Spannung (201) und dem Referenzpotential (202) betrieben wird; und
- die Offset-Spannung (333) der Hälfte einer Spannungsdifferenz zwischen der Betriebs-Spannung (201) und dem Referenzpotential (202) entspricht, oder um höchstens 5% davon abweicht.

9. Mess-Vorrichtung (110) gemäß einem der Ansprüche 6 bis 8, wobei

- die Ausgangsspannung (340) am Ausgang (313) des Operationsverstärkers (310) Werte aus einem möglichen Spannungsbereich annimmt und/oder eine dem Operationsverstärker (310) nachgeschaltete Mess- und/oder Auswerteelektronik ausgebildet ist, Messwerte aus dem möglichen Spannungsbereich zu erfassen; und
- die Offset-Spannung (333) der Hälfte des möglichen Spannungsbereichs entspricht.

10. Mess-Vorrichtung (110) gemäß einem der vorhergehenden Ansprüche, wobei

- die Mess-Vorrichtung (110) ausgebildet ist, an dem Ausgang (313) des Operationsverstärkers (310) als Messinformation eine Ausgangsspannung (320, 340) als Messung der Eingangsspannung (103) bereitzustellen; und
- die Ausgangsspannung (320, 340) insbesondere einer skalierten und/oder verschobenen Version der Eingangsspannung (103) entspricht.

**11.** Mess-Vorrichtung (110) gemäß Anspruch 10, wobei

- die Eingangsspannung (103) eine Amplitude von 100V oder mehr aufweist; und
- die Ausgangsspannung (320, 340) eine Amplitude von 50V oder weniger aufweisen.

**12.** Mess-Vorrichtung (110) gemäß einem der vorhergehenden Ansprüche, wobei die Mess-Vorrichtung (110) einen Komparator (410) umfasst, der ausgebildet ist, eine Ausgangsspannung an dem Ausgang (313) des Operationsverstärkers (310) mit einem von dem Referenzpotential (202, 332) abgeleiteten Vergleichspotential zu vergleichen.

**13.** Mess-Vorrichtung (110) gemäß Anspruch 12, wobei

- der Komparator (410) ausgebildet ist, als Ausgangssignal (405) des Komparators (410) einen Polaritätswechsel und/oder einen Nulldurchgang der Eingangsspannung (103) anzuzeigen;
- der Operationsverstärker (310) und der Komparator (410) zwischen einer Betriebs-Spannung (201) und dem Referenzpotential (202) oder zwischen einer positiven und einer negativen Betriebs-Spannung (201) betrieben werden; und
- das Vergleichspotential ein modifiziertes Referenzpotential (332) ist, das dem um eine Offset-Spannung (333) verschobenen Referenzpotential (202) entspricht.

**14.** Mess-Vorrichtung (110) gemäß einem der vorhergehenden Ansprüche, wobei die Mess-Vorrichtung (110) umfasst,

- einen Analog-Digital-Wandler, der eingerichtet ist, eine Ausgangsspannung (320, 340) am Ausgang (313) des Operationsverstärkers (310) oder eine davon abgeleitete Spannung in eine digitale Messspannung zu wandeln; und
- einen Prozessor, der eingerichtet ist, auf Basis der digitalen Messspannung als Messinformation

  - einen Messwert für die Eingangsspannung (103), insbesondere einen Messwert für eine Amplitude oder der gesamten Signalform der Eingangsspannung (103), zu ermitteln;
  - einen Polaritätswechsel und/oder einen Nulldurchgang der Eingangsspannung (103) zu detektieren; und/oder
  - eine Frequenz der Eingangsspannung (103) zu ermitteln.

**15.** Hausgerät (100), das umfasst,

- einen Netzanschluss (102) zur Anbindung des Hausgeräts (100) an eine AC-Versorgungsspannung (103);
- eine Mess-Vorrichtung (110) gemäß einem der vorhergehenden Ansprüche, wobei die Mess-Vorrichtung (110) eingerichtet ist, auf Basis der AC-Versorgungsspannung (103) Messinformation in Bezug auf die AC-Versorgungsspannung (103) zu ermitteln; und
- eine Steuereinheit (101), die eingerichtet ist, eine Funktion des Hausgeräts (100) in Abhängigkeit von der Messinformation zu betreiben.

**Fig. 1**

**Fig. 2**

Fig. 3a

**Fig. 3b**

**Fig. 3c**

Fig. 4a

Fig. 4b